# EUROPEAN PATENT APPLICATION

(11) **EP 4 704 512 A1**
(43) Date of publication of application: **04.03.2026**
(21) Application number: 25161774.2
(22) Date of filing: 05.03.2025
(51) Int. Cl.: H10B 41/50, H10B 43/50, H10B 41/27, H10B 43/27

(54) **SEMICONDUCTOR MEMORY DEVICE AND MANUFACTURING METHOD OF SEMICONDUCTOR MEMORY DEVICE**

(30) Priority: 27.08.2024 JP 2024145623
(71) Applicant: Kioxia Corporation, Tokyo 108-0023 (JP)
(72) Inventor: YAMADA, Kenta, Minato-ku, Tokyo, 108-0023 (JP)
(74) Representative: Hoffmann Eitle

(57) **Abstract**

According to one embodiment, a semiconductor memory device (1) includes a stacked body (LM) in which a plurality of first conductive layers (WL) and a plurality of insulating layers (OL) are alternately stacked one by one; a pillar (PL) that includes a semiconductor layer (CN) extending in the stacked body (LM) in a stacking direction of the stacked body (LM); a first layer (SL) that is arranged above the stacked body (LM) and has a semiconductor as a main component; and a second layer (TS) that is arranged above the first layer (SL) and has a metal as a main component, in which the pillar (PL) penetrates the first layer (SL), and the semiconductor layer (CN) protrudes into the second layer (TS).

## Description

### CROSS-REFERENCE TO RELATED APPLICATIONS

This application is based upon and claims the benefit of priority from Japanese Patent Application No. 2024-145623, filed on August 27, 2024; the entire contents of which are incorporated herein by reference.

### FIELD

Embodiments described herein relate generally to a semiconductor memory device and a manufacturing method of a semiconductor memory device.

### BACKGROUND

In a semiconductor memory device such as a three-dimensional nonvolatile memory, a pillar penetrating a stacked body in which a plurality of conductive layers and a plurality of insulating layers are alternately stacked is formed. At that time, in order to activate impurities in a source line connected to an upper end portion of the pillar, laser light or the like may be emitted from above the semiconductor memory device. However, impurities in the source line may not be sufficiently activated around the pillar adjacent to another member or the like.

### BRIEF DESCRIPTION OF THE DRAWINGS

Figs. 1A and 1B are diagrams illustrating a schematic configuration example of a semiconductor memory device according to an embodiment;
Figs. 2A to 2C are cross-sectional views illustrating an example of a configuration of a semiconductor memory device according to an embodiment;
Figs. 3A to 3C are diagrams sequentially illustrating a part of a procedure of a manufacturing method of a semiconductor memory device according to an embodiment;
Figs. 4A and 4B are diagrams sequentially illustrating a part of a procedure of a manufacturing method of a semiconductor memory device according to an embodiment;
Figs. 5A and 5B are diagrams sequentially illustrating a part of a procedure of a manufacturing method of a semiconductor memory device according to an embodiment;
Figs. 6A and 6B are diagrams sequentially illustrating a part of a procedure of a manufacturing method of a semiconductor memory device according to an embodiment;
Figs. 7A and 7B are diagrams sequentially illustrating a part of a procedure of a manufacturing method of a semiconductor memory device according to an embodiment;
Figs. 8A and 8B are diagrams sequentially illustrating a part of a procedure of a manufacturing method of a semiconductor memory device according to an embodiment;
Figs. 9A and 9B are diagrams sequentially illustrating a part of a procedure of a manufacturing method of a semiconductor memory device according to an embodiment;
Figs. 10A and 10B are diagrams sequentially illustrating a part of a procedure of a manufacturing method of a semiconductor memory device according to an embodiment;
Figs. 11A to 11D are diagrams sequentially illustrating a part of a procedure of a manufacturing method of a semiconductor memory device according to an embodiment;
Figs. 12A and 12B are diagrams sequentially illustrating a part of a procedure of a manufacturing method of a semiconductor memory device according to an embodiment;
Figs. 13A and 13B are diagrams illustrating a forming method of a source line of a semiconductor memory device according to a comparative example; and
Figs. 14A to 14D are diagrams illustrating a forming method of a source line of a semiconductor memory device according to a comparative example.

### DETAILED DESCRIPTION

In general, according to one embodiment, a semiconductor memory device includes a stacked body in which a plurality of first conductive layers and a plurality of insulating layers are alternately stacked one by one; a pillar that includes a semiconductor layer extending in the stacked body in a stacking direction of the stacked body; a first layer that is arranged above the stacked body and has a semiconductor as a main component; and a second layer that is arranged above the first layer and has a metal as a main component, in which the pillar penetrates the first layer, and the semiconductor layer protrudes into the second layer.

Hereinafter, embodiments of the present invention will be described in detail with reference to the drawings. The present invention is not limited to the following embodiments. In addition, constituent elements in the following embodiments include those that can be easily assumed by those skilled in the art or those that are substantially the same.

### (Configuration Example of Semiconductor Memory Device)

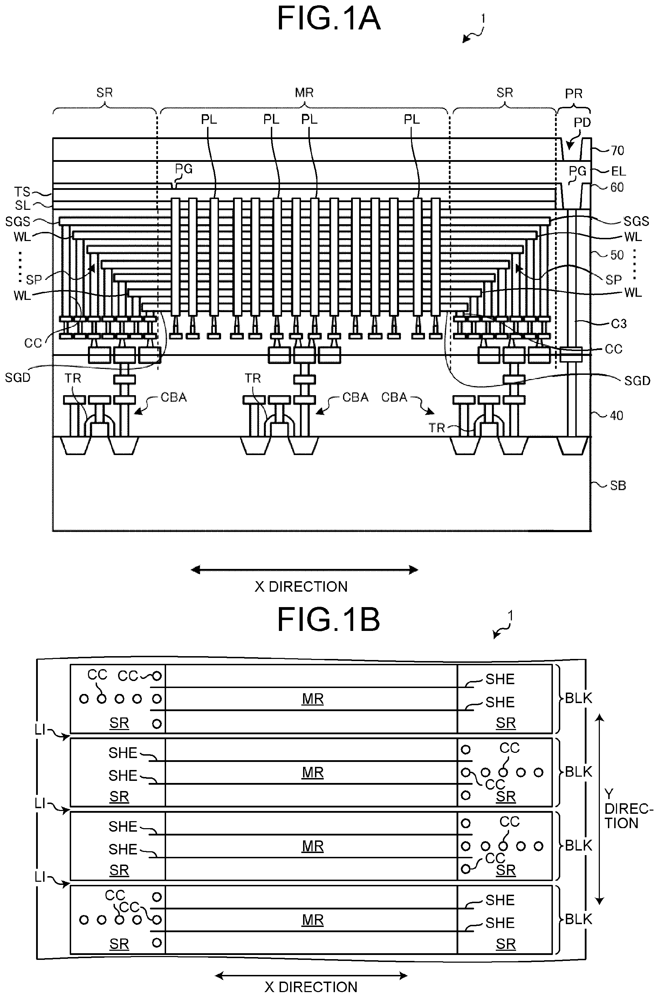

Figs. 1A and 1B are diagrams illustrating a schematic configuration example of a semiconductor memory device 1 according to the embodiment. More specifically, Fig. 1A is a cross-sectional view of the semiconductor memory device 1 along an X direction, and Fig. 1B is a schematic plan view illustrating a layout of the semiconductor memory device 1.

However, in Fig. 1A, hatching is omitted in consideration of visibility of the drawing. In addition, in Fig. 1A, configurations that do not necessarily exist in the same cross section are illustrated, and some upper layer wirings and the like are omitted.

In addition, in the present specification, both the X direction and the Y direction are directions along the direction of the surface of a word line WL, and the X direction and the Y direction are orthogonal to each other. In addition, an electrical drawing direction of the word line WL may be referred to as a first direction, and the first direction is a direction along the X direction. In addition, a direction intersecting the first direction may be referred to as a second direction, and the second direction is a direction along the Y direction. However, since the semiconductor memory device 1 may include a manufacturing error, the first direction and the second direction are not necessarily orthogonal to each other.

As illustrated in Fig. 1A, the semiconductor memory device 1 includes a semiconductor substrate SB, a peripheral circuit CBA, one or more selection gate lines SGD, a plurality of word lines WL, one or more selection gate lines SGS, a source line SL, an electrode film EL, and the like in this order from the bottom of the paper.

The semiconductor substrate SB is, for example, a silicon substrate or the like. The peripheral circuit CBA including transistors TR, wirings, and the like is arranged on the surface of the semiconductor substrate SB, and the entire peripheral circuit CBA is covered with an insulating layer 40. Above the semiconductor substrate SB on which the peripheral circuit CBA and the like are arranged, the plurality of word lines WL and the selection gate lines SGD and SGS entirely covered with an insulating layer 50 are arranged.

As illustrated in Figs. 1A and 1B, a memory region MR is arranged at the center of the plurality of word lines WL and the like in the X direction, and a staircase region SR is arranged at each of both end portions of the plurality of word lines WL and the like in the X direction. The memory region MR and the staircase regions SR are divided into a plurality of regions by a plurality of plate-shaped contacts LI penetrating the plurality of word lines WL and the like and extending in the direction along the X direction.

Note that a region arranged between the plate-shaped contacts LI adjacent in the Y direction and including the memory region MR and the staircase regions SR is referred to as a block region BLK. As will be described later, the memory region MR includes a plurality of memory cells that hold data in a nonvolatile manner, and the block region BLK is an erase unit of the data.

In addition, between the plate-shaped contacts LI adjacent in the Y direction, a plurality of separation layers SHE penetrating the selection gate lines SGD and extending in the direction along the X direction are arranged. The plurality of separation layers SHE extend in the direction along the X direction over the entire memory region MR, and reach a part of the staircase regions SR at both end portions in the X direction.

In the memory region MR, a plurality of pillars PL are arranged. The plurality of pillars PL penetrate the plurality of word lines WL, the selection gate lines SGD and SGS, and the source line SL that is arranged above the word lines WL and the selection gate lines SGD and SGS, and one end portion thereof protrudes into a metal layer TS arranged further above the source line SL.

The electrode film EL is arranged above the metal layer TS with an insulating layer 60 interposed therebetween. The entire electrode film EL except for a pad region PD, which is provided in a peripheral region PR positioned on the outer side of the word lines WL and the like in the X direction, is covered with an insulating layer 70. The insulating layer 70 has a configuration in which, for example, a silicon oxide layer, a silicon nitride layer, a polyimide layer, and the like are stacked from the lower layer side.

The electrode film EL is connected to the source line SL, a through contact C3, and the like by a plug PG or the like penetrating the insulating layer 60. The through contact C3 is provided in the peripheral region PR, passes through the insulating layer 50 covering the word lines WL and the like and the insulating layer 40 covering the peripheral circuit CBA, and is connected to the semiconductor substrate SB on which the peripheral circuit CBA is arranged.

From the outside of the semiconductor memory device 1, the semiconductor substrate SB is controlled to a predetermined potential through the pad region PD and the through contact C3. In addition, power and signals from the outside are supplied from the pad region PD to the semiconductor memory device 1.

A plurality of memory cells are formed at intersections of the pillars PL and the word lines WL. As a result, the semiconductor memory device 1 is configured as, for example, a three-dimensional nonvolatile memory in which memory cells are three-dimensionally arranged in the memory region MR.

In the staircase region SR, a staircase portion SP in which the plurality of word lines WL and the selection gate lines SGD and SGS are processed in a staircase shape and terminated is arranged. The separation layer SHE extends from the memory region MR to a portion where the selection gate line SGD of the staircase region SR is processed in a staircase shape. As a result, in one block region BLK, the selection gate line SGD is separated into a plurality of regions. In other words, the separation layer SHE penetrates portions below the plurality of word lines WL, so that these portions are partitioned into patterns of the plurality of selection gate lines SGD.

In each terrace portion of each stage formed by the plurality of word lines WL and the selection gate lines SGD and SGS, contacts CC that extend upward through the insulating layer 50 and are connected to the word lines WL and the selection gate lines SGD and SGS of each layer are arranged.

Note that in the present specification, a direction in which terrace surfaces of the plurality of word lines WL and the selection gate lines SGD and SGS face is defined as a lower side of the semiconductor memory device 1.

In the word line WL and the selection gate line SGS, one contact CC is connected for each layer. In the selection gate line SGD, one contact CC is connected for each section separated by the separation layer SHE per layer.

Here, in one block region BLK, the plurality of contacts CC are arranged on one side of the staircase regions SR on both sides in the X direction. In addition, when viewed on one side in the X direction, for example, a plurality of contacts CC are arranged every two of the block regions BLK.

That is, in the example of Fig. 1B, in the block region BLK on the uppermost side of the paper, a plurality of contacts CC are arranged, for example, in the staircase region SR on the left side in the drawing out of the staircase regions SR at both end portions in the X direction. In addition, in the block region BLK one and two layers below the above-described block region BLK, a plurality of contacts CC are arranged in the staircase region SR on the right side in the paper out of the staircase regions SR at both end portions in the X direction. Furthermore, in the block region BLK in the lowermost side in the paper, a plurality of contacts CC are arranged again in the staircase region SR on the left side in the paper.

Therefore, the contacts CC of each of the staircase regions SR at both end portions in the X direction illustrated in Fig. 1A belong to different block regions BLK, and are not actually positioned in the same cross section.

The word lines WL and the like stacked in multiple layers are individually drawn out by these contacts CC. More specifically, a write voltage, a read voltage, and the like are applied from these contacts CC to the memory cells included in the memory region MR at the center of the plurality of word lines WL through the word lines WL at the same height position as the memory cells.

Note that the semiconductor memory device 1 of the embodiment is configured by bonding the insulating layer 40 covering the peripheral circuit CBA and the insulating layer 50 covering the word lines WL and the like to each other. In this manner, the insulating layers 40 and 50 function as bonding layers. In addition, by bonding the insulating layers 40 and 50, the electrode pads arranged on the surfaces of the insulating layers 40 and 50 are connected to each other, so that the peripheral circuit CBA is electrically connected to the contacts CC, the plurality of word lines WL, the selection gate lines SGS and SGD, and the pillars PL.

The application of the predetermined voltage from the contact CC to the memory cell is controlled by the peripheral circuit CBA electrically connected to these configurations. In this manner, the peripheral circuit CBA controls the electrical operation of the memory cell.

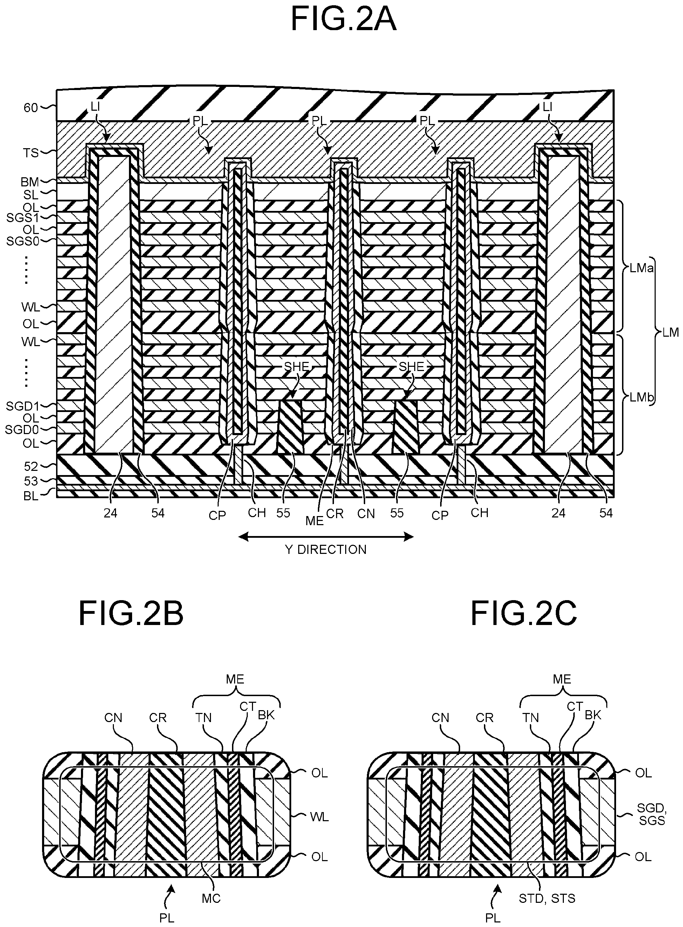

Next, a detailed configuration example of the semiconductor memory device 1 will be described with reference to Figs. 2A to 2C. Figs. 2A to 2C are cross-sectional views illustrating an example of the configuration of the semiconductor memory device 1 according to the embodiment.

More specifically, Fig. 2A is a cross-sectional diagram along the Y direction in the memory region MR of the semiconductor memory device 1. In Fig. 2A, structures above the insulating layer 60 and below an insulating layer 52 to be described later are omitted.

Fig. 2B is an enlarged cross-sectional view of the pillar PL at the height position of the word line WL. Fig. 2C is an enlarged cross-sectional view of the pillar PL at the height positions of the selection gate lines SGD and SGS.

As illustrated in Fig. 2A, the metal layer TS, a barrier metal layer BM, and the source line SL are arranged below insulating layer 60 in order from the side of insulating layer 60.

The insulating layer 60 is, for example, a silicon oxide layer or the like. The metal layer TS is, for example, a tungsten layer or the like, and functions as a source line metal of the semiconductor memory device 1 in addition to the lower source line SL. The barrier metal layer BM is, for example, at least one of a titanium layer, a titanium nitride layer, a tantalum layer, or a tantalum nitride layer, and suppresses diffusion of tungsten atoms from the metal layer TS to a nearby configuration.

The source line SL is, for example, a polycrystalline semiconductor layer such as a polysilicon layer, and is doped with N-type impurities containing at least either arsenic or phosphorus. The source line SL has a function as the source line and a function as a stopper layer at the time of forming the pillar PL in a manufacturing process of the semiconductor memory device 1 to be described later.

Below the source line SL, a stacked body LM is arranged in which a plurality of word lines WL and a plurality of insulating layers OL are alternately stacked one by one. The stacked body LM includes a stacked body LMa arranged below the source line SL and a stacked body LMb arranged further below the stacked body LMa.

The stacked body LMa includes selection gate lines SGS1 and SGS0 in order from the source line SL side on a further upper layer of the uppermost word line WL. These selection gate lines SGS1 and SGS0 are source-side selection gate lines.

The stacked body LMb includes selection gate lines SGD1 and SGD0 in order from the lowermost word line WL side on a further lower layer of the lowermost word line WL. These selection gate lines SGD1 and SGD0 are drain-side selection gate lines.

However, the number of layers of the word lines WL and the selection gate lines SGS and SGD included in the stacked body LM is arbitrary. Therefore, the stacked body LM may include one of each selection gate lines SGS and SGD, or three or more of each selection gate line SGS and SGD. The plurality of word lines WL and the selection gate lines SGS and SGD are, for example, tungsten layers or molybdenum layers, and the plurality of insulating layers OL are, for example, silicon oxide layers.

Insulating layers 52 and 53 are arranged below the stacked body LM in order from the stacked body LM side. These insulating layers 52 and 53 constitute a part of the above-described insulating layer 50 (refer to Fig. 1A).

As described above, the plurality of plate-shaped contacts LI extend in a stacking direction of the stacked body LM and the direction along the X direction. More specifically, the plate-shaped contact LI penetrates the stacked body LM and the source line SL, and has an upper end portion protruding into the metal layer TS. A lower end portion of the plate-shaped contact LI in the metal layer TS is covered with the barrier metal layer BM.

Each of these plate-shaped contacts LI includes a conductive layer 24 such as a tungsten layer and an insulating layer 54 covering a side wall of the conductive layer 24. The insulating layer 54 also covers the upper end portion of the conductive layer 24 protruding into the metal layer TS.

In addition, the plate-shaped contact LI has, for example, a tapered shape in which the width in the Y direction is increased from the upper end portion toward the lower end portion. Alternatively, the plate-shaped contact LI has, for example, a bowing shape in which the width in the Y direction is maximized at a predetermined position between the upper end portion and the lower end portion.

Among the plurality of plate-shaped contacts LI, between the plate-shaped contacts LI adjacent in the Y direction, one or more separation layers SHE extend in the direction along the X direction, in the lower layer portion of the stacked body LM. In the example of Fig. 2A, the separation layer SHE penetrates the selection gate lines SGD0 and SGD1 described above, and reaches the insulating layer OL adjacent to the selection gate line SGD1 in the stacking direction. As a result, the selection gate lines SGD0 and SGD1 are divided into a plurality of sections.

In addition, between the plate-shaped contacts LI adjacent in the Y direction, the plurality of pillars PL extend in the stacking direction of the stacked body LM, in the stacked body LM. More specifically, these pillars PL extend in the stacked body LM in the stacking direction of the stacked body LM from the insulating layer OL on the lowermost layer of the stacked body LM, and penetrate the stacked body LM and the source line SL.

The plurality of pillars PL are arranged, for example, in a staggered pattern when viewed in the stacking direction of the stacked body LM. Each pillar PL has, for example, a circular shape, an elliptical shape, an oval shape (oval shape), or the like as a cross-sectional shape in a direction along a layer direction of the stacked body LM, that is, in a direction along the XY plane.

In addition, the pillar PL has a tapered shape in which the diameter and the cross-sectional area are increased from the upper layer side toward the lower layer side in a portion penetrating the stacked body LMa and a portion penetrating the stacked body LMb, respectively. Alternatively, the pillar PL has a bowing shape in which the diameter and the cross-sectional area are maximized, for example, at a predetermined position between the upper layer side and the lower layer side in a portion penetrating the stacked body LMa and a portion penetrating the stacked body LMb.

In addition, the pillar PL includes a core layer CR serving as a core material, a channel layer CN covering a side wall of the core layer CR, a memory layer ME covering a side wall of the channel layer CN, and a cap layer CP arranged at a lower end portion of the pillar PL.

Among the core layer CR, the channel layer CN, and the memory layer ME, the memory layer ME penetrates the stacked body LM and the source line SL and reaches the barrier metal layer BM. Each of the core layer CR and the channel layer CN penetrates the stacked body LM and the source line SL, and has an upper end portion protruding into the metal layer TS. A lower end portion of the channel layer CN in the metal layer TS is covered with the barrier metal layer BM.

That is, a portion of the channel layer CN protruding into the metal layer TS is not covered with the memory layer ME, and the channel layer CN is in direct contact with the barrier metal layer BM. As a result, the channel layer CN is electrically connected to the source line SL through the barrier metal layer BM.

The cap layer CP arranged at the lower end portion of the pillar PL connects the channel layer CN to a plug CH extending by penetrating the insulating layer OL on the lowermost layer of the stacked body LM and the insulating layer 52 below the insulating layer OL. The plug CH connects a bit line BL arranged in the insulating layer 53 to the pillar PL arranged in the stacked body LM. The bit line BL extends below the stacked body LM in the direction along the Y direction so as to intersect with the drawing direction of the word lines WL.

As illustrated in Figs. 2B and 2C, the memory layer ME includes a stacked structure including a block insulating layer BK, a charge storage layer CT, and a tunnel insulating layer TN in this order from the outer peripheral side of the pillar PL. The charge storage layer CT of the memory layer ME is, for example, a silicon nitride layer or the like. The block insulating layer BK and the tunnel insulating layer TN of the memory layer ME, and the core layer CR are, for example, silicon oxide layers or the like. The channel layer CN and the cap layer CP are, for example, polycrystalline semiconductor layers such as polysilicon layers.

Note that at least a portion of the channel layer CN protruding into the metal layer TS may contain N-type impurities of the same type as the impurities with which the source line SL is doped, such as arsenic or phosphorus.

As illustrated in Fig. 2B, with the above configuration, memory cells MC are formed in portions facing the individual word lines WL on the side surface of the pillar PL. In a case where a predetermined voltage is applied from the word line WL, data is written to and read from the memory cell MC.

As illustrated in Fig. 2C, selection gates STD are formed in portions where the side surface of the pillar PL faces the selection gate lines SGD0 and SGD1, respectively. In addition, selection gates STS are formed in portions where the side surface of the pillar PL faces the selection gate lines SGS0 and SGS1 below the word lines WL, respectively.

In a case where a predetermined voltage is applied from each of the selection gate lines SGD and SGS, the selection gates STD and STS are turned on or off, and the memory cells MC of the pillar PL to which the selection gates STD and STS belong can be brought into a selected state or a non-selected state.

### (Manufacturing Method of Semiconductor Memory Device)

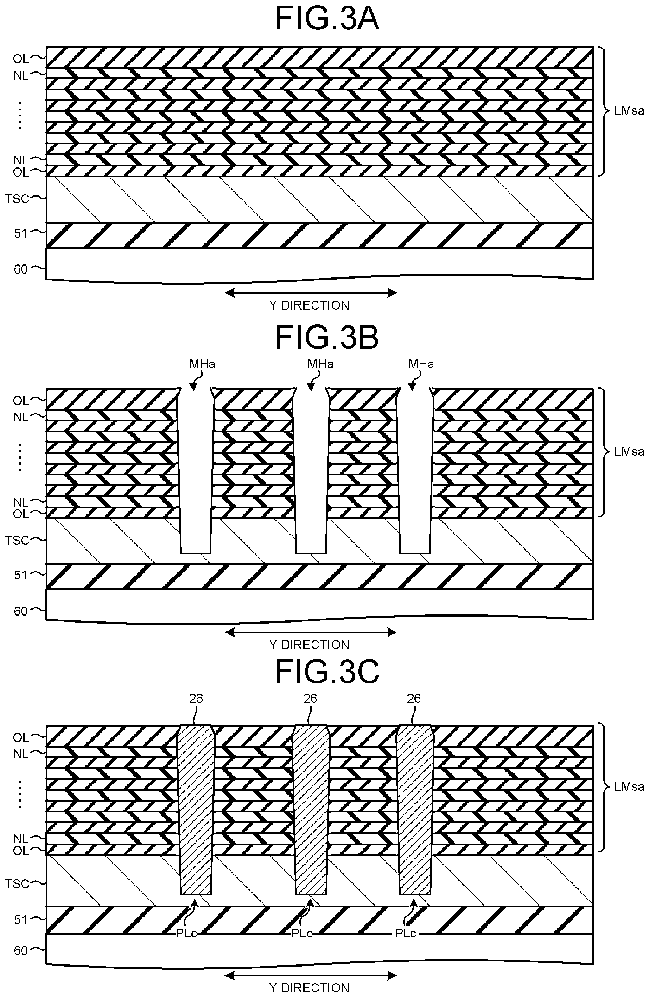

Next, a manufacturing method of the semiconductor memory device 1 according to the embodiment will be described with reference to Figs. 3A to 12B. Figs. 3A to 12B are diagrams sequentially illustrating a part of a procedure of the manufacturing method of the semiconductor memory device 1 according to the embodiment. More specifically, Figs. 3A to 12B illustrate cross sections of a region to be the memory region MR later, along the Y direction.

Note that, in the following description, a direction in which a surface of a support substrate SS to be described later or the semiconductor substrate SB on a side on which various kinds of processing are performed faces is defined as an upper side of the semiconductor memory device 1 in the middle of manufacturing. In other words, the upper side in the paper of the following drawings is the upper side of the semiconductor memory device 1 in the middle of manufacturing, and the lower side in the paper is the lower side of the semiconductor memory device 1 in the middle of manufacturing.

As illustrated in Fig. 3A, the support substrate SS is prepared. As the support substrate SS, a semiconductor substrate such as a silicon substrate, an insulating substrate such as a ceramic substrate, a conductive substrate, or the like can be used.

Hereinafter, the configuration to be the source line SL later, the stacked body LM, the pillars PL, and the like are formed on the upper surface of the support substrate SS. The formation process is performed in a state in which the up-down direction is inverted compared to the examples of Figs. 1A and 2A described above.

First, an insulating layer 51 and a semiconductor layer TSC are formed in this order on the support substrate SS. The semiconductor layer TSC is a non-doped polysilicon layer, a polycrystalline semiconductor layer, or the like.

In addition, a stacked body LMsa in which a plurality of insulating layers NL and a plurality of insulating layers OL are alternately stacked one by one is formed on the semiconductor layer TSC. The insulating layer NL is, for example, a silicon nitride layer or the like, and functions a sacrificial layer which is later replaced by a conductive material to form the word lines WL or the selection gate lines SGS.

Thereafter, although not illustrated, the insulating layers NL and the insulating layers OL are processed in a staircase shape in a partial region of the stacked body LMsa. Such processing can be performed by repeating the slimming of a mask pattern such as a photoresist layer, and the etching of the insulating layer NL and the insulating layer OL of the stacked body LMsa a plurality of times.

That is, the mask pattern is formed on the upper surface of the stacked body LMsa, and the insulating layer NL and the insulating layer OL in the exposed portion are etched away one by one. In addition, by processing with oxygen plasma or the like, the end portion of the mask pattern is retracted to newly expose the upper surface of the stacked body LMsa, and the insulating layer NL and the insulating layer OL are further etched away one by one. By repeating such processing a plurality of times, the stacked body LMsa having a staircase shape is formed at both end portions in the X direction.

Thereafter, the staircase shape at both end portions in the X direction is covered with a part of the above-described insulating layer 50 (refer to Fig. 1A).

As illustrated in Fig. 3B, a plurality of memory holes MHa extending in the stacking direction of the stacked body LMsa is formed. At this time, the semiconductor layer TSC below the stacked body LMsa functions as a stopper layer. Therefore, the plurality of memory holes MHa penetrate the stacked body LMsa, and reach a predetermined depth of the semiconductor layer TSC. These memory holes MHa are portions that later become the pillars PL penetrating the stacked body LMa.

As illustrated in Fig. 3C, the memory holes MHa are filled with a sacrificial layer 26 such as a CVD-carbon layer. As a result, pillars PLc in which the plurality of memory holes MHa are filled with the sacrificial layer 26 are formed.

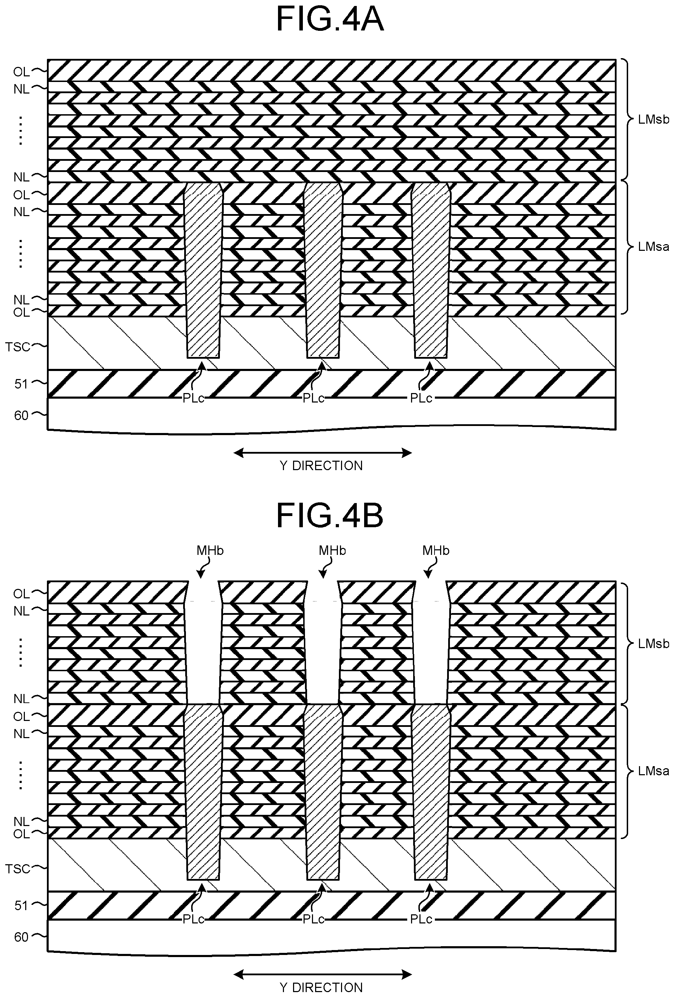

As illustrated in Fig. 4A, a stacked body LMsb that covers the stacked body LMsa and in which a plurality of insulating layers NL and a plurality of insulating layers OL are alternately stacked one by one is formed. The insulating layers NL of the stacked body LMsb function as sacrificial layers that are later replaced with the conductive layers to become the word lines WL or the selection gate lines SGD.

Thereafter, although not illustrated, the insulating layers NL and the insulating layers OL are processed in a staircase shape in a partial region of the stacked body LMsb. Similarly to the processing for the stacked body LMsa described above, such processing can be performed by repeating the slimming of a mask pattern such as a photoresist layer, and the etching of the insulating layer NL and the insulating layer OL of the stacked body LMsb a plurality of times.

At this time, the uppermost step of the staircase portion formed in the stacked body LMsa and the lowermost step of the staircase portion formed in the stacked body LMsb are brought close to each other to form a continuous staircase shape continuously from the lower layer side of the stacked body LMsa to the upper layer side of the stacked body LMsb. As a result, the stacked bodies LMsa and LMsb are formed in which the staircase region SR having a staircase shape from the stacked body LMsa to the stacked body LMsb is formed at both end portions in the X direction.

Thereafter, the staircase shape at both end portions in the X direction is further covered with a part of the above-described insulating layer 50 (refer to Fig. 1A).

As illustrated in Fig. 4B, a plurality of memory holes MHb penetrating the stacked body LMsb and being respectively connected to the plurality of pillars PLc formed in the stacked body LMsa are formed. The memory holes MHb are portions that later become the pillars PL penetrating the stacked body LMb.

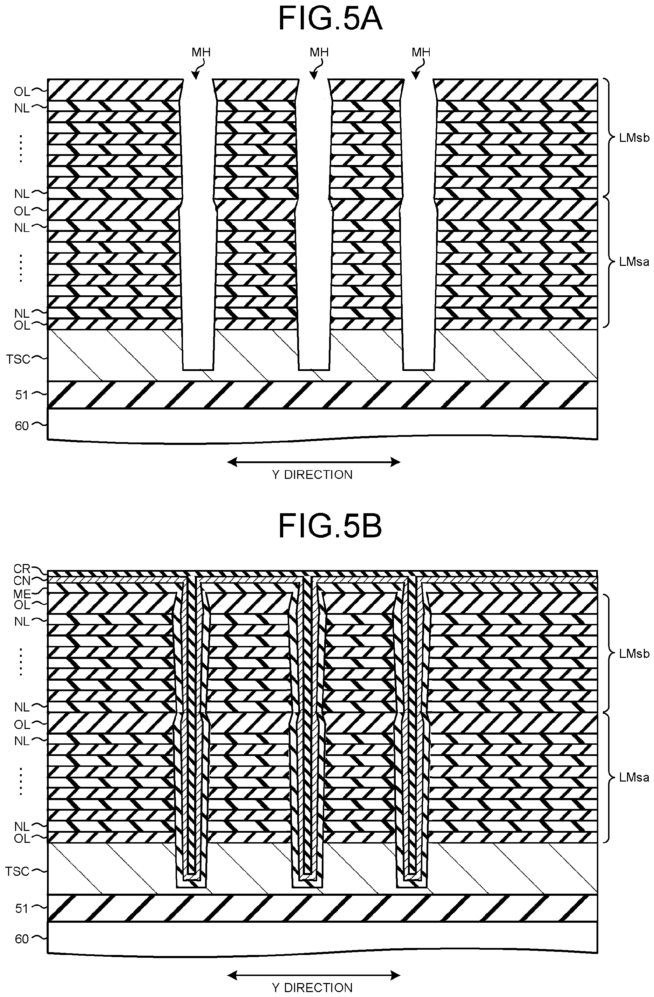

As illustrated in Fig. 5A, the sacrificial layer 26 is removed from the pillar PLc at the bottom of the memory hole MHb. As a result, the memory holes MHa are opened at the bottoms of the plurality of memory holes MHb, and a plurality of memory holes MH penetrating the stacked bodies LMsb and LMsa and reaching a predetermined depth of the source line SL are formed.

Note that, in a case where the sacrificial layer 26 filled in the pillars PLc is a CVD-carbon layer or the like, the sacrificial layer 26 can be collectively removed from the pillars PLc when the mask pattern or the like used at the time of forming the memory holes MHb in Fig. 4B described above is removed by ashing or the like using oxygen plasma.

As illustrated in Fig. 5B, the memory layer ME including the block insulating layer BK, the charge storage layer CT, and the tunnel insulating layer TN (refer to Figs. 2B and 2C) in this order from the side wall side of the memory hole MH is formed on the side wall and the bottom surface of the memory hole MH. The memory layer ME is also formed on the upper surface of the stacked body LMsb.

In addition, the channel layer CN and the core layer CR are formed in this order in the memory hole MH through the memory layer ME. As a result, the channel layer CN is formed on the memory layer ME covering the side surface and the bottom surface of the memory hole MH, and the core layer CR is filled in the central portion of the memory hole MH. The channel layer CN and the core layer CR are also formed in this order on the upper surface of the stacked body LMsb through the memory layer ME.

Note that the channel layer CN is not doped with impurities at this time point, and may be in an amorphous state such as an amorphous silicon layer.

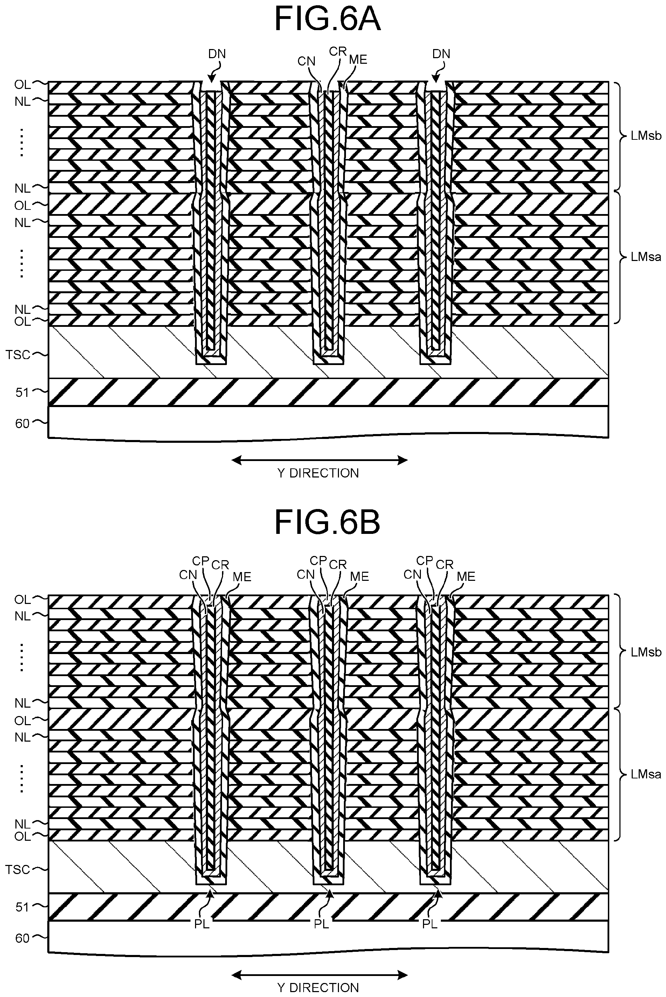

As illustrated in Fig. 6A, the core layer CR, the channel layer CN, and the memory layer ME that are formed on the upper surface of the stacked body LMsb are etched back and removed together with a part of the insulating layer OL on the uppermost layer of the stacked body LMsb, and the core layer CR is retracted to a predetermined depth of the memory hole MH to form a recess DN at the upper end portion of the memory hole MH.

As illustrated in Fig. 6B, the cap layer CP is formed in the recess DN at the upper end portion of the memory hole MH. At this point, the cap layer CP may be in an amorphous state such as an amorphous silicon layer.

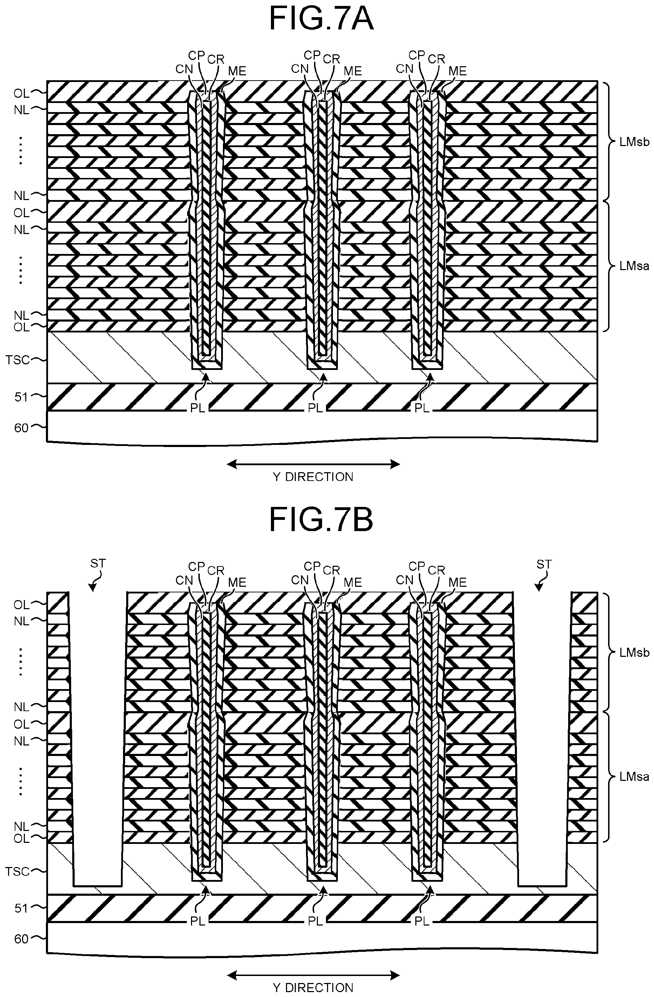

As illustrated in Fig. 7A, by etching back the core layer CR, the channel layer CN, the memory layer ME, and the like formed on the upper surface of the stacked body LMsb, the insulating layer OL on the uppermost layer of the stacked body LMb of which the film has been reduced is stacked. As a result, the pillar PL in which the upper end portion is buried in the insulating layer OL on the uppermost layer of the stacked body LMsb is formed. However, at this point, the memory layer ME covers the channel layer CN at the lower end portion of the pillar PL.

As illustrated in Fig. 7B, a slit ST that penetrates the stacked bodies LMsb and LMsa and reaches a predetermined depth of the semiconductor layer TSC is formed. The slit ST also extends in the stacked bodies LMsa and LMsb in the direction along the X direction.

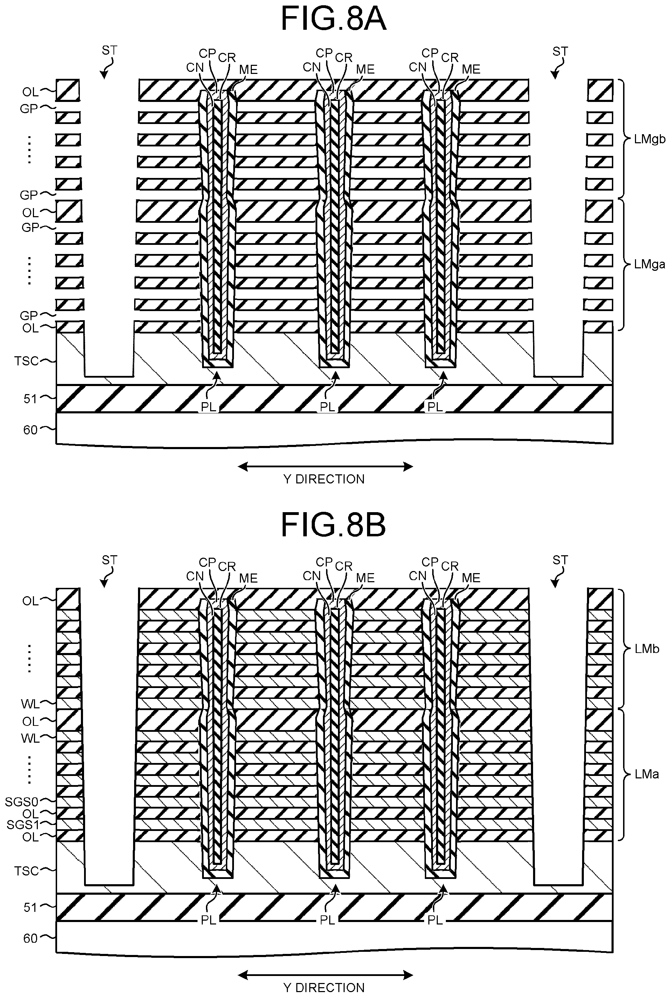

As illustrated in Fig. 8A, by allowing a removing liquid for the insulating layers NL such as, for example, hot phosphoric acid to flow into the stacked bodies LMsa and LMsb from the slit ST, the insulating layers NL of the stacked bodies LMsa and LMsb are removed. As a result, stacked bodies LMga and LMgb having a plurality of gap layers GP obtained by removing the insulating layers NL between the insulating layers OL are formed.

The stacked bodies LMga and LMgb including the plurality of gap layers GP have a fragile structure. The plurality of pillars PL support such fragile stacked bodies LMga and LMgb. As a result, the bending of the insulating layers OL remaining in the stacked bodies LMga and LMgb and the distortion or collapse of the stacked bodies LMga and LMgb are suppressed.

As illustrated in Fig. 8B, a source gas of a conductive material such as tungsten or molybdenum is injected from the slits ST into the stacked bodies LMga and LMgb to fill the gap layers GP of the stacked bodies LMga and LMgb with the conductive material, and thereby the plurality of word lines WL and the like are formed. As a result, the stacked body LM including the stacked bodies LMa and LMb in which the plurality of word lines WL and the like and the plurality of insulating layers OL are alternately stacked one by one is formed.

As described above, the processing of forming the word lines WL from the insulating layers NL is also referred to as replacement processing.

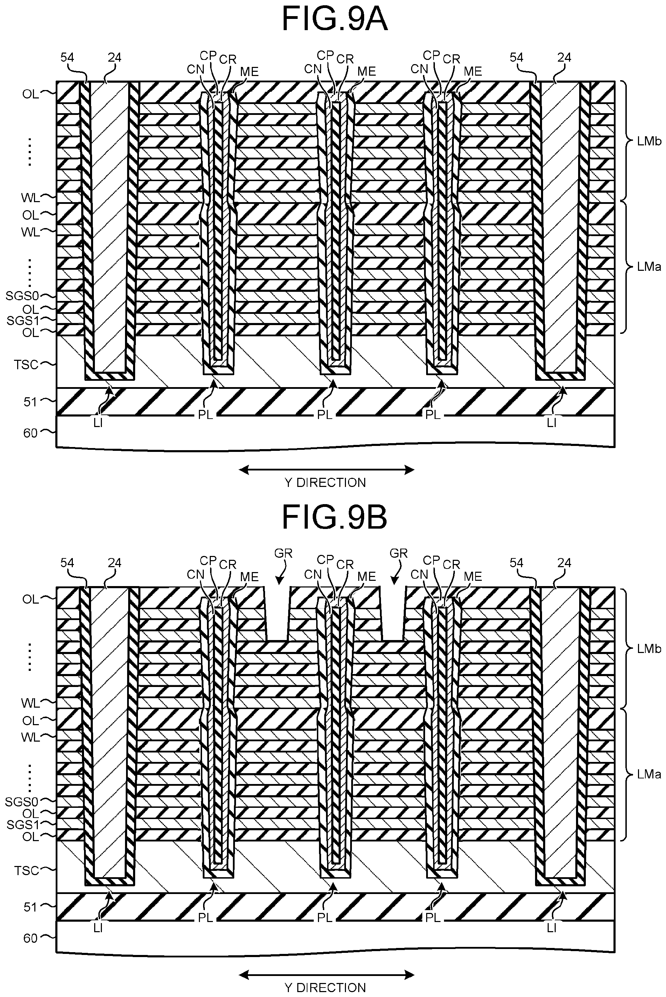

As illustrated in Fig. 9A, the conductive layer 24 is filled in the slit ST through the insulating layer 54 to form the plate-shaped contact LI.

As illustrated in Fig. 9B, a groove GR penetrating one or a plurality of conductive layers including the conductive layer on the uppermost layer of the stacked body LMb is formed.

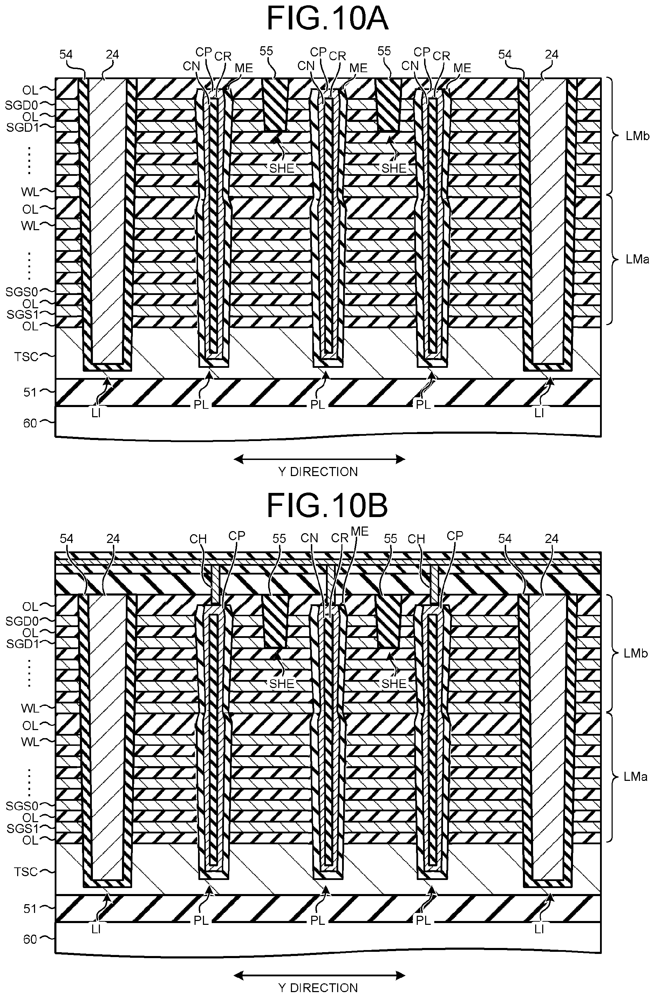

As illustrated in Fig. 10A, an insulating layer 55 is filled in the groove GR to form the separation layer SHE that partitions the conductive layer on the upper layer side of the stacked body LM into a pattern of the selection gate lines SGD.

In addition, although not illustrated, a plurality of contacts CC reaching the word lines WL and the selection gate lines SGD and SGS constituting the respective steps of the staircase structure of the staircase region SR from the upper side of the staircase region SR are formed.

As illustrated in Fig. 10B, after the insulating layer 52 covering the stacked body LM is formed, the plug CH penetrating the insulating layer OL on the uppermost layer of the stacked body LM and the insulating layer 52 and being connected to the cap layer CP at the upper end portion of the pillar PL is formed. In addition, the insulating layer 53 covering the insulating layer 52 is formed, and the bit line BL to which each plug CH is connected is formed in the insulating layer 53.

Note that, for example, the plug CH, the bit line BL, and the like may be collectively formed by using a dual damascene method or the like.

In addition, although not illustrated, the peripheral circuit CBA is formed on the semiconductor substrate SB separate from the support substrate SS on which the stacked body LM is formed, and is covered with the insulating layer 40. In the insulating layer 40, a contact, a via, a wiring, or the like that draws out the peripheral circuit CBA to the surface of the insulating layer 40 is formed and connected to the electrode pad or the like formed on the upper surface of the insulating layer 40.

In addition, the support substrate SS and the semiconductor substrate SB are bonded by the insulating layers 50 and 40 of the support substrate SS and the semiconductor substrate SB, and the electrode pads in the insulating layers 50 and 40 are connected. These insulating layers 50 and 40 can be joined by being activated in advance by, for example, plasma treatment or the like. In addition, by performing an annealing treatment after the insulating layers 50 and 40 are bonded, the electrode pads in the insulating layers 50 and 40 can be connected by Cu-Cu bonding or the like.

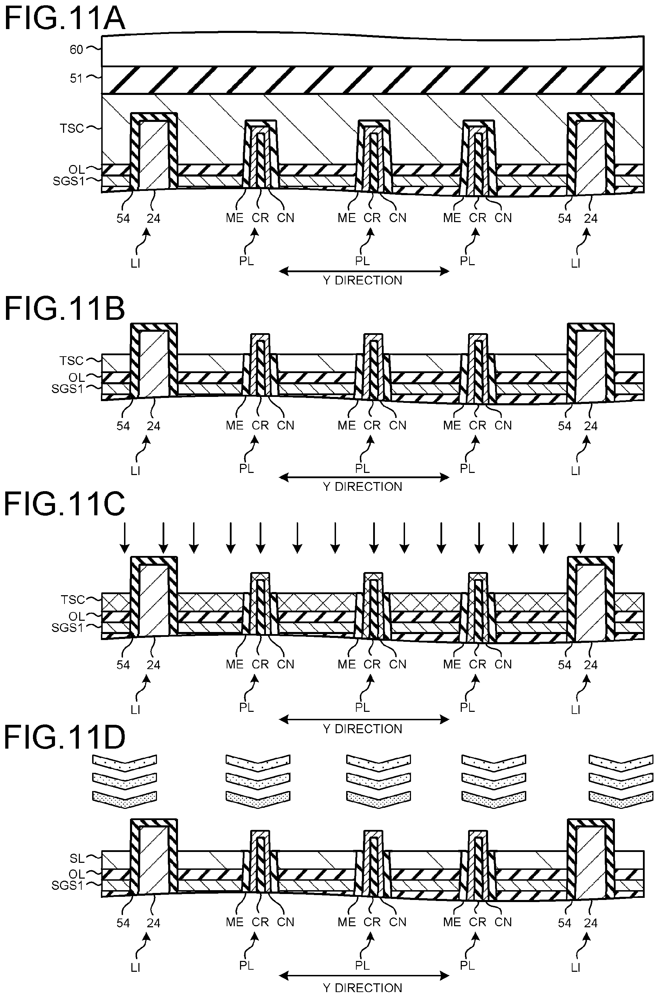

As illustrated in Fig. 11A, thereafter, various kinds of processing are performed from the side of the support substrate SS that is bonded on the semiconductor substrate SB in an upside down manner. Therefore, in the following drawings, a state is illustrated in which various kinds of processing are performed from the upper end portion side of the pillars PL and the plate-shaped contacts LI with the portions of the pillars PL and the plate-shaped contacts LI protruding to the semiconductor layer TSC as the upper end portion.

Note that in the following drawings, only the upper end portions of the pillars PL and the plate-shaped contacts LI are illustrated.

As illustrated in Fig. 11B, the support substrate SS is removed by cleaving the interface between the insulating layer 51 and the support substrate SS. Furthermore, the insulating layer 51 in the memory region MR in which the pillars PL and the like are formed is removed, and the semiconductor layer TSC is further removed with a predetermined layer thickness left. As a result, in the memory region MR, the upper end portions of the pillars PL and the plate-shaped contacts LI penetrate the thinned semiconductor layer TSC and protrude upward.

In addition, the memory layer ME is removed from the portion of the pillar PL protruding above the semiconductor layer TSC. As a result, the upper end portion of the channel layer CN of the pillar PL is exposed above the semiconductor layer TSC. At this time, the insulating layer 54 of the plate-shaped contact LI is thicker than the memory layer ME, and thus remains without being removed. In a case where the insulating layer 54 is formed by the processing of Fig. 9A described above, the stopper layer such as a silicon nitride layer may be formed in the insulating layer 54 to protect the inner insulating layer 54.

As illustrated in Fig. 11C, the semiconductor layer TSC is sequentially subjected to the implant treatment with phosphorus, arsenic, or the like, for example, and thus the semiconductor layer TSC is doped with N-type impurities. At this time, the upper end portion of the channel layer CN may also be doped with the impurities. By being doped with the impurities, the entire semiconductor layer TSC and at least the upper end portion of the channel layer CN become an amorphous semiconductor layer such as an amorphous silicon layer.

As illustrated in Fig. 11D, the semiconductor layer TSC is irradiated with the laser light, and the semiconductor layer TSC is annealed by heat of the laser light. At this time, for example, the laser light having a wavelength of 540 nm such as a green laser can be used. In a case where laser light having a wavelength of 540 nm is used, the semiconductor layer TSC can be heated to, for example, about 1100°C.

As described above, by performing the annealing treatment using the laser light, the semiconductor layer TSC amorphized by being doped with the impurities is polycrystallized, and the N-type impurities with which the semiconductor layer TSC is doped can be activated. In addition, the amorphized channel layer CN is also polycrystallized by the annealing treatment.

As described above, the source line SL that is an N-doped polysilicon layer or the like is formed.

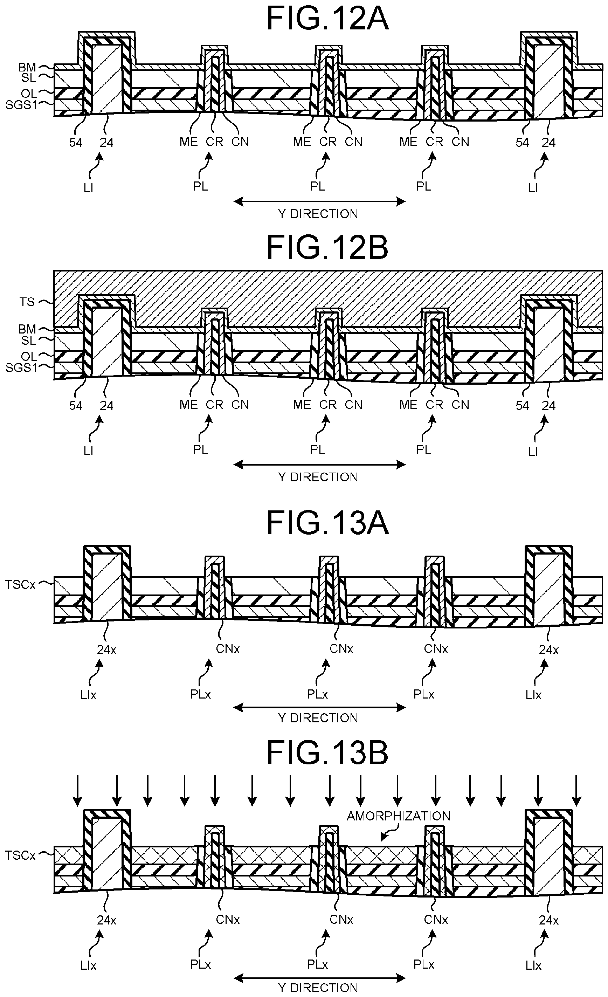

As illustrated in Fig. 12A, the barrier metal layer BM is formed which covers the source line SL and the lower end portions of the channel layer CN of the pillar PL and the plate-shaped contact LI that protrude above the source line SL.

As illustrated in Fig. 12B, the metal layer TS covering the barrier metal layer BM is formed.

Thereafter, the insulating layer 60 is formed on the metal layer TS, and the plug PG penetrating the insulating layer 60 is formed. In addition, the electrode film EL connected to the plug PG in the insulating layer 60 is formed, and the insulating layer 70 covering the electrode film EL is formed. Furthermore, an opening portion is provided in the insulating layer 70 to expose a part of the electrode film EL, thereby forming the pad region PD.

As described above, the semiconductor memory device 1 according to the embodiment is manufactured.

### (Overview)

The semiconductor memory device such as a three-dimensional nonvolatile memory may be manufactured by forming the peripheral circuit including the transistor and the like and the stacked body including the word line, the pillar PL, and the like, on separate substrates and bonding these substrates.

In addition, the source line connected to the pillar may be formed from the back surface side of the support substrate that supports the stacked body or the like after the substrates are bonded to each other, and at this time, the source line is doped with N-type impurities or the like and activated by the annealing treatment using the laser light. A state at this time is illustrated in Figs. 13 A to 14D.

Figs. 13A to 14D are diagrams illustrating a forming method of a source line of a semiconductor memory device according to a comparative example.

As illustrated in Fig. 13A, on the upper surface of the semiconductor substrate in which the peripheral circuit and the stacked body are bonded, a semiconductor layer TSCx, a pillar PLx having a channel layer CNx of which the upper end portion protrudes above the semiconductor layer TSCx, and a plate-shaped contact LI having a conductive layer 24x of which the upper end portion protrudes above the semiconductor layer TSCx are formed. As described above, the state of the semiconductor memory device of the comparative example in Fig. 13A corresponds to the state of Fig. 11B of the above-described embodiment.

As illustrated in Fig. 13B, the semiconductor layer TSCx and the upper end portion of the channel layer CNx of the pillar PLx are doped with impurities such as phosphorus. As a result, the entire semiconductor layer TSCx and the upper end portion of the channel layer CNx are amorphized. The state of the semiconductor memory device of the comparative example in Fig. 13B corresponds to the state of Fig. 11C of the above-described embodiment.

As described above, the processing so far is performed also in the semiconductor memory device of the comparative example similarly to Figs. 11B and 11C of the above-described embodiment, for example.

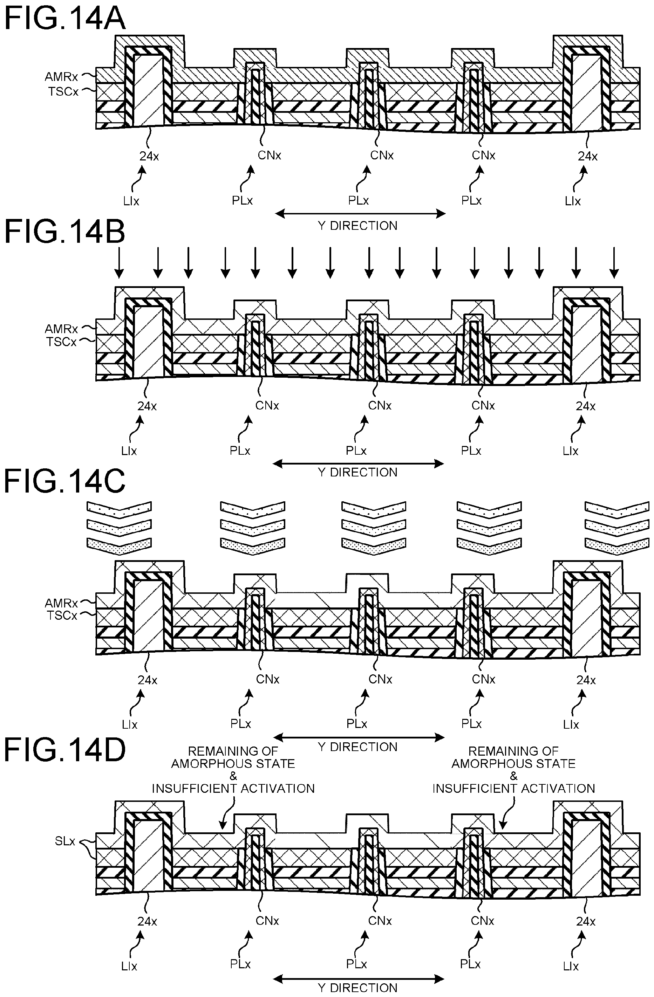

As illustrated in Fig. 14A, in the semiconductor memory device of the comparative example, a semiconductor layer AMRx covering the semiconductor layer TSCx is formed. The semiconductor layer AMRx is an amorphous semiconductor layer such as an amorphous silicon layer, and is formed in order to absorb laser light and use the laser light as a heat generation source at the time of the subsequent annealing treatment with laser light.

As illustrated in Fig. 14B, the semiconductor layer AMRx and the upper end portion of the channel layer CNx of the pillar PLx are doped with impurities such as arsenic.

As illustrated in Fig. 14C, the semiconductor layer AMRx and the upper end portion of the channel layer CNx of the pillar PLx are irradiated with the laser light. At this time, the amorphous semiconductor layer such as the semiconductor layer AMRx absorbs laser light and functions as the heat generation source.

Therefore, as described above, the semiconductor layer AMRx is heated by the laser light, and the heat of the semiconductor layer AMRx is further transmitted to the semiconductor layer TSCx and the upper end portion of the channel layer CNx of the pillar PLx, and the semiconductor layers AMRx and TSCx and the channel layer CNx are annealed. Therefore, the semiconductor layers AMRx and TSCx can be polycrystallized, and impurities in the semiconductor layers AMRx and TSCx can be activated.

As described above, the source line SLx of the comparative example includes the semiconductor layers AMRx and TSCx containing activated impurities. However, as illustrated in Fig. 14D, in the semiconductor memory device of the comparative example, impurities in the source line SLx may not be sufficiently activated around the pillars PLx adjacent to the plate-shaped contacts LIx.

The present inventors have conducted intensive studies to solve the above problems, and have found that heat due to the laser light is dissipated to the conductive layer 24x having a relatively large volume of the plate-shaped contact LIx. In addition, it has been clarified that such heat dissipation occurs through the semiconductor layer AMRx covering the entire pillar PLx and the plate-shaped contact LIx.

As a result, in the vicinity of the plate-shaped contact LIx, the temperature of the semiconductor layers AMRx and TSCx is rapidly decreased, or the temperature of the semiconductor layers AMRx and TSCx cannot be sufficiently increased in the first place, and impurities cannot be activated.

Therefore, the present inventor has further studied a method of performing the annealing treatment on the semiconductor layer TSCx without using the semiconductor layer AMRx serving as the heat generation source. As a result, the present inventors have found that the semiconductor layer TSCx itself doped with impurities such as phosphorus and amorphized can be used as the heat generation source by laser light.

According to the semiconductor memory device 1 of the embodiment, the pillar PL penetrates the source line SL, and the channel layer CN of the pillar PL protrudes into the metal layer TS. In this manner, by eliminating the semiconductor layer AMRx serving as a heat generation source at the time of emitting the laser light, the dissipation of heat to the plate-shaped contact LI through the semiconductor layer AMRx is suppressed, and impurities in the source line SL can be activated even around the pillars PL adjacent to the plate-shaped contacts LI.

With the semiconductor memory device 1 of the embodiment, the channel layer CN of the pillar PL is electrically connected to the source line SL through the barrier metal layer BM. As described above, even in the configuration in which the semiconductor layer AMRx is eliminated and the pillar PL penetrates the source line SL, it is possible to connect the channel layer CN of the pillar PL to the source line SL.

The semiconductor memory device 1 according to the embodiment further includes the plate-shaped contacts LI having the conductive layer 24 that extends in the stacked body LM in the stacking direction of the stacked body LM and the direction along the X direction, at a position adjacent to the pillar PL. As described above, also in a region where the plate-shaped contact LI is arranged adjacent to the pillar PL, by eliminating the semiconductor layer AMRx continuously covering the upper end portion of the plate-shaped contact LI from the arrangement region of the pillar PL, it is possible to suppress the heat due to the laser light from being dissipated to the plate-shaped contact LI.

With the semiconductor memory device 1 according to the embodiment, the conductive layer 24 of the plate-shaped contacts LI penetrates the source line SL and protrudes into the metal layer TS. Even in such a configuration, since there is no semiconductor layer AMRx that covers the plate-shaped contact LI and promotes heat dissipation to the plate-shaped contact LI at the time of emitting the laser light, the impurities in the source line SL can be activated.

In addition, the conductive layer 24 may not be provided in the plate-shaped contact LI. In this case, for example, instead of the conductive layer 24, a SiOx layer, a SiGe layer, or the like can be used for the plate-shaped contact LI. Even in this case, the same effect can be obtained.

With the semiconductor memory device 1 of the embodiment, the source line SL is a polycrystalline semiconductor layer containing N-type impurities. The source line SL is once formed in an amorphous state by such doping with impurities. As a result, the semiconductor layer TSC itself doped with impurities and amorphized can be used as the heat generation source to perform the annealing treatment by emitting the laser light, thereby activating the impurities.

Note that, in the above-described embodiment, the semiconductor memory device 1 includes the stacked body LM having a two-tier structure in which the two stacked bodies LMa and LMb are stacked vertically. However, the configuration of the stacked body is not limited to two tiers, and may be one tier or three tiers or more.

In addition, in the above-described embodiment, the staircase region SR is arranged at both end portions of the stacked body LM in the X direction. However, the staircase region may be arranged at the center of the stacked body in the X direction, and the memory regions MR may be arranged at both end portions in the X direction.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor memory device (1) comprising:
a stacked body (LM) in which a plurality of first conductive layers (WL) and a plurality of insulating layers (OL) are alternately stacked one by one;
a pillar (PL) that includes a semiconductor layer (CN) extending in the stacked body (LM) in a stacking direction of the stacked body (LM);
a first layer (SL) that is arranged above the stacked body (LM) and has a semiconductor as a main component; and
a second layer (TS) that is arranged above the first layer (SL) and has a metal as a main component,
wherein the pillar (PL) penetrates the first layer (SL), and
the semiconductor layer (CN) protrudes into the second layer (TS).

2. The semiconductor memory device (1) according to claim 1, wherein
the semiconductor layer (CN) is electrically connected to the first layer (SL) through the second layer (TS).

3. The semiconductor memory device (1) according to claim 1, further comprising:
a plate-shaped portion (LI) having a second conductive layer (24) that extends in the stacked body (LM) in the stacking direction and a first direction intersecting the stacking direction, at a position adjacent to the pillar (PL).

4. The semiconductor memory device (1) according to claim 3, wherein
the second conductive layer (24) penetrates the first layer (SL) and protrudes into the second layer (TS).

5. The semiconductor memory device (1) according to claim 1, further comprising:
a first bonding layer (50) that is arranged below the stacked body (LM) and covers the stacked body (LM);
a peripheral circuit (CBA) that is arranged below the stacked body (LM) and contributes to an electrical operation of the pillar (PL); and
a second bonding layer (40) that is arranged above the peripheral circuit (CBA), covers the peripheral circuit (CBA), and is bonded to the first bonding layer (50).

6. The semiconductor memory device (1) according to claim 1, wherein
the first layer (SL) is a polycrystalline semiconductor layer containing first conductivity type impurities.

7. A manufacturing method of a semiconductor memory device (1), the manufacturing method comprising:
forming, on a first layer (SL) having a semiconductor as a main component, a stacked body (LM) in which a plurality of first conductive layers (WL) and a plurality of insulating layers (OL) are alternately stacked one by one and a pillar (PL) including a semiconductor layer (CN) extending in the stacked body (LM) in a stacking direction of the stacked body (LM);
removing the first layer (SL) with a predetermined thickness left to expose one end portion of the semiconductor layer (PL); and
injecting first conductivity type impurities to the left first layer (SL) and emitting laser light.

8. The manufacturing method of a semiconductor memory device (1) according to claim 7, further comprising:
before the first layer (SL) is removed, forming a plate-shaped portion (LI) having a second conductive layer (24) that extends in the stacked body (LM) in the stacking direction and a first direction intersecting the stacking direction, at a position adjacent to the pillar (PL).

9. The manufacturing method of a semiconductor memory device (1) according to claim 8, wherein
the removal of the first layer (SL) includes exposing one end portion of the plate-shaped portion (LI) together with the one end portion of the semiconductor layer (PL).

10. The manufacturing method of a semiconductor memory device (1) according to claim 9, wherein
the emission of the laser light includes emitting the laser light to the one end portion of each of the semiconductor layer (CN) and the plate-shaped portion (LI) together with the first layer (SL).

11. The manufacturing method of a semiconductor memory device (1) according to claim 7, further comprising:
doping the first layer (SL) with first conductivity type impurities before emitting the laser light.

12. The manufacturing method of a semiconductor memory device (1) according to claim 11, wherein
the emission of the laser light includes polycrystallizing the first layer (SL) that has become amorphous due to the doping with the impurities.
